# EUROPÄISCHE PATENTANMELDUNG

(11) **EP 0 878 559 A1**
(43) Veröffentlichungstag der Anmeldung: **18.11.1998**
(21) Anmeldenummer: 98106695.4
(22) Anmeldetag: 11.04.1998
(51) Int. Cl.: C23C 14/56, B65G 17/12

(54) **Vorrichtung für den Transport von scheibenförmigen Substraten**

(30) Priorität: 09.05.1997 DE 29708315 U
(71) Anmelder: Leybold Systems GmbH, D-63450 Hanau am Main (DE)
(72) Erfinder: Szellas, Stefan, 24631 Langwedel (DE); Sauer, Peter, 36381 Schlüchtern (DE)

(57) **Zusammenfassung**

Bei einer Vorrichtung für die Magazinisierung von scheibenförmigen Substraten (15,15',...) in einer Vakuumbeschichtungsanlage umfassend eine motorische Antriebseinheit (4) mit einem von dieser angetriebenen, ebenen, formschlüssigen Zugmittelgetriebe (7,8,9) mit einem über ein Zahnscheibenpaar (7,8) geführten endlosen Zahnriemen (9) sind eine Vielzahl von auf der Außenseite des flachen Zahnriemen (9) des offenen Riemengetriebes in gleichmäßigen Abständen fest angeordnete, sich lotrecht vom Riementrum nach außen zu erstreckende Arme (10,10',...)vorgesehen, deren freie Enden (21,21',...) jeweils rechtwinklig abgebogen sind und sich parallel zu den Rotationsachsen der Zahnscheiben (7,8) erstrecken und jeweils einen Substrathalter (14,14',...) aufweisen.

## Beschreibung

Die Neuerung betrifft eine Vorrichtung für den Transport von scheibenförmigen Substraten in einer Vakuumbeschichtungsanlage oder für deren Magazinierung mit einer motorischen Antriebseinheit mit einem von dieser angetriebenen, ebenen, formschlüssigen Zugmittelgetriebe mit mindestens zwei Zahnscheiben und einem über das Zahnscheibenpaar geführten endlosen Zahnriemen.

Bekannt ist eine Vorrichtung zum Transport von scheibenförmigen Substraten mit Hilfe von zwei offenen Flachriemengetrieben, bei denen die Rotationsachsen der Leitrollen der Flachriemen winklig zueinander angeordnet und die beiden Lasttrums in parallelen Ebenen laufen (GB 2 170 164 A).

Weiterhin ist ein Substrat-Förderapparat bekannt mit einer endlosen Kette, die mindestens zwischen einem Paar von Kettenrädern umläuft, einer quer verlaufenden Basisplatte, die quer zur Förderrichtung der endlosen Kette verläuft und an der endlosen Kette befestigt ist, einer Druckleiste oder -stange, die von der Querbasisplatte oder der endlosen Kette gehalten ist und mit Bezug auf die Querbasisplatte geöffnet werden kann, mindestens einer ortsfest angeordneten Kurvenbahn oder -schiene für Kurvenfolgerollen, die an der Querbasisplatte befestigt bzw. mit der Druckleiste oder -stange verbunden sind und beim Eintreffen der Querbasisplatte in eine Substrat-Aufnahmeposition die Druckleiste oder -stange öffnen sowie die Druckleiste oder -stange schließen, bis die Querbasisplatte eine vorbestimmte Position erreicht und einem Anischlag, der entweder an der Querbasisplatte oder an der Druckleiste oder -stange befestigt ist und an dem das jeweilige zwischen die Querbasisplatte und die Druckleiste oder -stange eintretende Substrat zur Anlage gelangt (DE-OS 35 16 853 A1).

Bekannt ist schließlich eine Vorrichtung für den Transport von scheibenförmigen Substraten durch eine Behandlungsstation oder von einer ersten zu einer zweiten Bearbeitungsstation einer Vakuumbeschichtungsanlage, bei der eine motorische Antriebseinheit mit drei von dieser angetriebenen, ebenen, formschlüssigen zugmittelgetrieben mit jeweils mindesten zwei Zahnscheiben und jeweils einem über jedes Zahnscheibenpaar geführten Zahnriemen vorgesehen sind, wobei zwei dieser Zugmittelgetriebe so zueinander angeordnet sind, daß ihre Zahnscheiben sich in einer gemeinsamen Ebene und ihre Zahnriemen sich zumindest mit jeweils einem Trum parallel und im Anstand zueinander erstrecken, und wobei die Zahnscheiben eines dritten Zugmittelgetriebes sich in einer Ebene erstrecken, die rechtwinklig zur Ebene der Zahnriemen der beiden anderen zugmittelgetriebe verläuft, wobei zumindest ein Trum des dritten Zugmittelgetriebes parallel des Trums der beiden anderen Zugmittelgetriebe verläuft, und wobei alle drei einander zu-geneigten Trums der drei Zugmittelgetriebe den Außenrand von kreisscheibenförmigen Substraten tangieren, deren Durchmesser dem Anstand entsprechen, den die beiden einander parallelen Trums der beiden ersten Zugmittelgetriebe voneinander aufweisen und die sich in Ebenen quer zu diesen Trums erstrecken, wobei die Zahnriemen der drei Zugmittelgetriebe auf ihren einander zugekehrten Außenflächen mit quer verlaufenden Rippen oder Zähnen versehen sind, deren Anstände und Anzahl jeweils denjenigen der in die Zahnscheiben eingreifenden Zähnen der Zahnriemen entsprechen (DE-OS 43 41 634 A1).

Der vorliegenden Neuerung liegt die Aufgabe zugrunde, eine Vorrichtung der infrage stehenden Art zu schaffen, die bei minimalem Platzbedarf geeignet ist eine große Anzahl von Substraten, beispielsweise von Compact Discs (CD's) in der Vorrichtung zur Herstellung der Substrate über eine Umwegstrecke zu fördern, um den vom Herstellungsprozeß stark erwärmten Substraten Gelegenheit zur Ankühlung zu geben.

Diese Aufgabe wird gemäß der Neuerung durch eine Vielzahl von auf der Außenseite des flachen Zahnriemens des offenen Riemengetriebes in gleichmäßigen Anständen fest angeordneten, sich lotrecht vom Riementrum nach außen zu erstreckenden Arme gelöst, deren freie Enden jeweils rechtwinklig abgebogen sind und sich parallel zu den Rotationsachsen der Zahnscheiben erstrecken und jeweils mit einem Substrathalter versehen sind.

Weitere Einzelheiten und Merkmale sind in den Schutzansprüchen näher beschrieben und gekennzeichnet.

Die Neuerung läßt die verschiedensten Ausführungsmöglichkeiten zu; eine davon ist in den anhängenden Zeichnungen rein schematisch näher dargestellt, und zwar zeigen:
- Fig. 1: die Vorrichtung nach der Neuerung in der Vorderansicht,

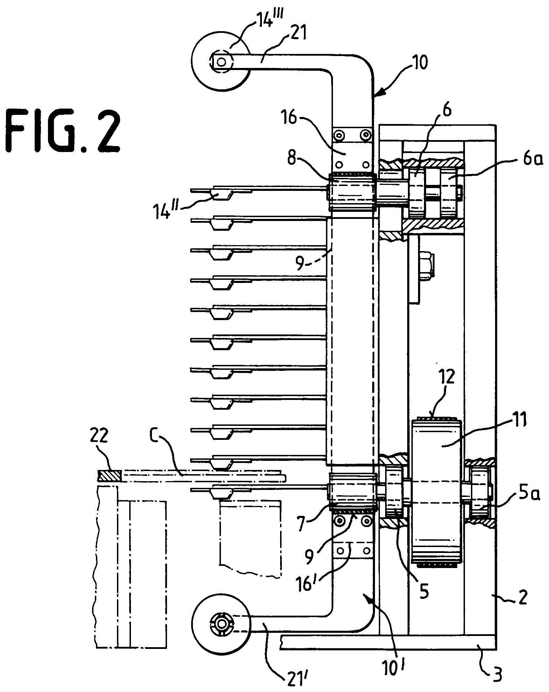

- Fig. 2: die Vorrichtung gemäß Fig. 1 in der Seitenansicht,
- Fig. 3: einen einzelnen Substrathalter der Vorrichtung im Längsschnitt und im Zusammenwirken mit einem kreisscheibenförmigen Substrat und
- Fig. 4: den Substrathalter nach Fig. 3 in der Draufsicht.

Die Vorrichtung besteht im wesentlichen aus einem kastenförmigen Lagergestell 2, einer Grundplatte 3 mit der im Anstand zum Lagergestell 2 vorgesehenen Motor-Getriebeeinheit 4, den beiden vom Lagergestell 2 gehaltenen Lagerpaaren 5,5a bzw. 6,6a für die Zahnscheiben 7 und 8, den Zahnriemen 9, den auf den Außenseiten des Zahnriemens 9 fest angeordneten, von Klemmstücken 16,16',... gehaltenen Armen 10,10',..., mit Substrathaltern 14,14',..., der Riemenscheibe 11 mit Flachriemen 12 und der von der Motor-Getriebeeinheit 4 angetriebenen Antriebswelle 13.

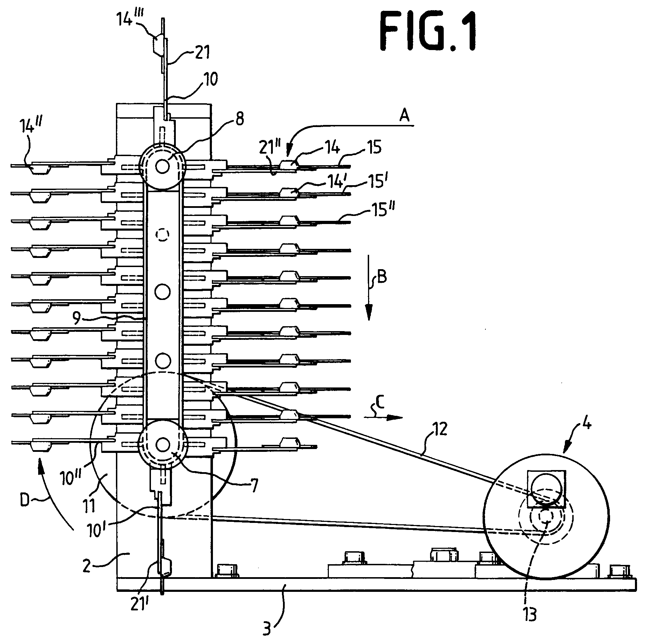

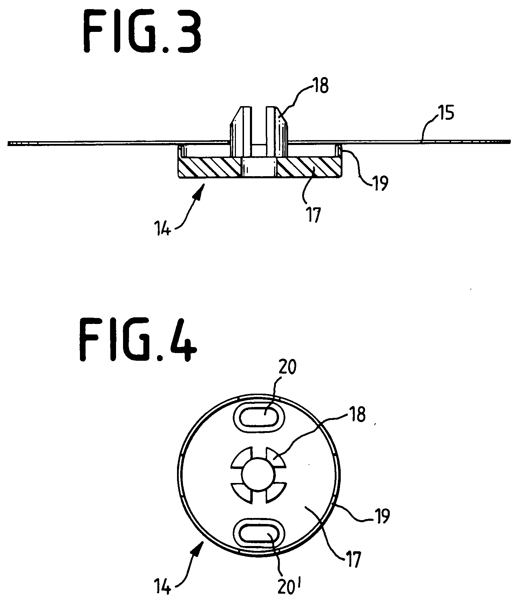

Die vom Herstellungsprozeß noch aufgeheizten Substrate 15,15',... werden von einer nicht näher dargestellten Fördereinrichtung in die Position A gebracht (Fig. 1) und dort auf dem in seiner oberen Stellung befindlichen Substrathalter 14 abgelegt. Da der Zahnriemen in Pfeilrichtung B umläuft (d. h. bezogen auf die Darstellung gemäß Fig. 1 im Uhrzeigersinn), bewegt sich das Substrat 15 schrittweise abwärts, bis das Substrat die Position C erreicht hat, in der es vom Substratträger 14 abgenommen und von einer nicht näher dargestellten zweiten Fördereinrichtung weiterbefördert wird. Die rechtwinklig gebogenen Arme 10,10',... mit den an ihren äußeren Enden jeweils fest angeordneten Substrathaltern 14,14',... werden nun weiterbewegt, bis sie sich auf der in Fig. 1 linken Vorrichtungsseite in Pfeilrichtung D aufwärts bewegen und schließlich wider die Übernahmeposition A er-reichen. Da die Motor-Getriebeeinheit 4 die Zahnscheibe 7 nur schrittweise im Uhrzeigersinn bewegt, benötigt jedes in der Position A übernommene Substrat 15,15',... eine längere Zeit, um schließlich die Angabeposition C zu erreichen, so daß die zeit hierfür ausreicht, die Substrate 15,15',... abzukühlen. Die an den rechtwinklig abgebogenen enden der Arme 10,10',... befestigten Substrathalter 14,14',... (Fig. 3 und 4) bestehen jeweils aus einer Basisplatte 17 mit in deren Zentrum angeordneten Zapfen oder Nocken 18,18',... und einer kreisringförmigen Randpartie 19. Außerdem sind sie mit Paaren von Langlöchern 20,20',... versehen, die der Befestigung der aus einem Kunststoff gefertigten Substrathalter 14,14',... an den Armen 10,10',... dienen.

### Bezugszeichenliste

- 2: Lagergestell
- 3: Grundplatte
- 4: Motor-Getriebeeinheit
- 5,5a: Lager
- 6,6a: Lager
- 7: Zahnscheibe
- 8: Zahnscheibe
- 9: Zahnriemen
- 10,10',...: Arm
- 11: Riemenscheibe
- 12: Flachriemen
- 13: Antriebsscheibe
- 14,14',...: Substrathalter
- 15,15',...: Substrat
- 16,16',...: Klemmstück
- 17: Basisplatte
- 18,18',...: Zapfen, Nocken
- 19: Randpartie, Kragen
- 20,20',...: Langloch
- 21,21',...: Armpartie
- 22: Transportvorrichtung

## Patentansprüche

1. Vorrichtung für den Transport von scheibenförmigen Substraten (15,15',...) in einer Vakuumbeschichtungsanlage oder für deren Magazinierung mit einer motorischen Antriebseinheit (4) mit einem von dieser angetriebenen, ebenen, formschlüssigen Zugmittelgetriebe (7,8,9) mit zwei Zahnscheiben (7,8) und einem über das Zahnscheibenpaar (7,8) geführten endlosen Zahnriemen (9) **gekennzeichnet durch** eine Vielzahl von auf der Außenseite des flachen Zahnriemen (9) des offenen Riemengetriebes in gleichmäßigen Anständen fest angeordneten, sich lotrecht vom Riementrum nach außen zu erstreckenden Armen (10,10',...), deren freie Enden (21,21',...) jeweils rechtwinklig abgebogen sind und sich parallel zu den Rotationsachsen der Zahnscheiben (7,8) erstrecken und jeweils mit einem Substrathalter (14,14',...) versehen sind.

2. Vorrichtung nach Anspruch 1, **dadurch gekennzeichnet,** daß die Substrathalter (14,14',...) jeweils aus einer Kreisscheibenförmigen Basisplatte (17) gebildet sind, deren schmale umlaufende Randpartie in achsialer Richtung mit einem leisten- oder wulstförmigen Kragen (199 und deren zentrale Partie mit einem oder mehreren Zapfen oder sich fingerartig in Achsrichtung erstreckenden Nocken (18) versehen ist.

3. Vorrichtung nach den Ansprüchen 1 und 2, **dadurch gekennzeichnet,** daß die Substrathalter (14,14',...) aus einem Kunststoff geringer Wärmeleitfähigkeit gebildet sind und mit den Armpartien (21,21',...) der Arme (10,10',...) vernietet, verschraubt oder verklebt sind.

4. Vorrichtung nach den Ansprüchen 1 bis 3, **dadurch gekennzeichnet,** daß die Zahnscheiben (7,8) lotrecht übereinander angeordnet sind, wobei die mit dem eine Trum sich abwärts bewegenden Arme (10,10',...) die Substrate (15,15',...) jeweils in ihrer oberen Position (A) von einer Zuführvorrichtung übernehmen und in ihrer unteren Position (C) an eine Weitertransportvorrichtung (22) übergeben.

5. Vorrichtung nach den vorhergehenden Ansprüchen, **dadurch gekennzeichnet**, daß die jeweils rechtwinklig abgebogenen Partien (21,21',...) aller mit dem Zahnriemen (9) fest verbundenen Arme (10,10',...) zu der den ortsfesten Lagern (5,5a bzw. 6,6a) der Zahnscheiben (7,8) abgekehrten Seite der Vorrichtung ausgerichtet sind.

6. Vorrichtung nach den vorhergehenden Ansprüchen, **dadurch gekennzeichnet**, daß die an den freien enden (21,21',...) der Arme (10,10',...) fest angeordneten Substrathalter (14,14',...) jeweils mit ihren Basisplatten (17) an den Enden (21,21',...) anliegen und ihre Kragenpartien (19) und Zapfen oder Nocken ken (18) nach der Umlaufrichtung des Zahnriemens (9) ausgerichtet sind.
